# EUROPEAN PATENT APPLICATION

(11) **EP 3 637 557 A1**
(43) Date of publication of application: **15.04.2020**
(21) Application number: 19201882.8
(22) Date of filing: 08.10.2019
(51) Int. Cl.: H01R 12/91, H01R 12/75

(54) **CONNECTION DEVICE AND METHOD OF ASSEMBLING A CONNECTION DEVICE**

(30) Priority: 09.10.2018 IT 201800009268
(71) Applicant: TE Connectivity Italia Distribution S.r.l., 10093 Collegno (TO) (IT); TE Connectivity Italia S.r.l., 10093 Collegno (TO) (IT)
(72) Inventor: Chiarelli, Davide, 10098 Torino (IT)
(74) Representative: Grünecker Patent- und Rechtsanwälte PartG mbB

(57) **Abstract**

A connection device for a printed circuit board (200) for connecting a plurality of PCB connectors (300) with a printed circuit board (200) is described, the connection device (100) comprises first and second positioning ribs (101, 102) adapted to be housed in first and second positioning recesses (201, 202), respectively, of the printed circuit board (200), wherein the connection device (100) comprises elastic means (103) placed between the first and second positioning ribs (101, 102), so that the distance between the first and second positioning ribs (101, 102) is adjustable by means of the deformation of the elastic means (103). Further described are an electronic module comprising a connection device (100) and a printed circuit board (200), a domestic appliance and a method of assembling a connection device (100) for a printed circuit board with a printed circuit board (200).

## Description

### TECHNICAL FIELD

The present invention relates to the field of connection devices for printed circuit boards (PCBs). In particular, the present invention relates to a connection device for connecting a plurality of PCB connectors with a printed circuit board (PCB).

### BACKGROUND ART

Printed circuit boards (PCBs) are employed in a wide range of electronic products, for example in domestic appliances or the like. PCBs mechanically support and electrically connect several electrical components that guarantee the functionality of the electronic product into which the PCBs are built in.

PCBs are electrically connected to each other and/or to further components of the final electronic products. Moreover, electrical connections are needed for supplying power to the PCB. These electrical connections are realized by means of so called PCB connectors which are very well known in the art. For example, these electrical connections may be realized by edge connectors which are a type of PCB connectors. For example, these connections may be realized by RAST-connectors, such as RAST 2.5 or RAST5 connectors.

A single PCB may be connected to several PCB connectors. For example, each PCB connector may be dedicated to a particular component of the final electronic product and/or to a particular function to be carried out in the architecture of the system. For example, a single PCB connector may be dedicated to power supply of the PCB.

Since the architecture of several final electronic products has increased in complexity due to the number of operations that such products are able to carry out, the architecture of the PCBs is increased in complexity as well and with that the number of PCB connectors to be connected to a single PCB is also increased.

One of the problems related to the increasing number of PCB connectors to be connected to a single PCB is that the assembly operations are rendered more time consuming and thus more costly. This is in particular the case when such assembly operations are carried out by the manufacturer of the final electronic products or even at the OEM (Original Equipment Manufacturer) level. Connecting several PCB connectors to a single PCB at this level of the manufacturing process is thus undesirable.

In order to overcome this problem, connection devices for PCBs have been developed, that allow connecting a plurality of PCB connectors to a single PCB in a single connection step. Basically, the plurality of PCB connectors is firstly connected to one of such connection devices. This operation may advantageously be carried out at the harness maker level. In other words, the harness maker may provide the connection device connected to a plurality of PCB connectors. Afterwards, the OEM or the manufacturer of the final electronic products simply connects the connection device to a single PCB with a single connection operation thus achieving the connection of several PCB connectors with the PCB with just this single operation. This is advantageous because the assembly operations at the OEM level are strongly simplified.

Nevertheless, such connection devices may present tolerance issues. In particular, mating the connection device with the PCB may be rendered difficult or inaccurate because of dimensional differences between the connection device and the PCB due, for example, to unavoidable manufacturing errors or to different thermal behavior of the connection device with respect to the PCB. This could result in contacts which are misaligned on the PCB. Moreover, even if appropriate mating is achieved when assembling the system, possible dimensional variations in the lifetime of the product, for example due to temperature changes or the like, could result in fretting corrosion or contact misalignments.

These issues become more critical if the length of the connection device is increased for allowing several PCB connectors to be connected with a single PCB by means of the connection device.

The present invention faces one or more of the above mentioned problems.

### SUMMARY OF THE INVENTION

The present invention is based on the idea of providing a connection device for printed circuit boards with positioning ribs which allow mating the connection device with the PCB, wherein the mutual distance between the positioning ribs is adjustable, in particular by means of elastic means. In particular, the elastic deformation of the elastic means is exploited in order to adjust the distance between the positioning ribs so as to join the connection device with the PCB. Moreover, elastic deformations of the elastic means reduce the risk of fretting corrosion or of contact misalignments during the lifetime of the product. In the ambit of the present invention, the term "elastic deformation" may independently refer to either an extension or a compression or both of the elastic means.

According to an embodiment of the present invention, a connection device for a printed circuit board for connecting a plurality of PCB connectors with a printed circuit board (PCB) is provided, wherein the connection device comprises first and second positioning ribs adapted to be housed in first and second positioning recesses, respectively, of the printed circuit board, wherein the connection device comprises elastic means placed between the first and second positioning ribs, so that the distance between the first and second positioning ribs is adjustable by means of the deformation of the elastic means. The first and second positioning ribs allow aligning and thus joining together in the correct manner the connection device with the PCB. In particular, when the first positioning rib of the connection device is housed in the first positioning recess of the PCB and the second positioning rib is housed in the second positioning recess, the connection device and the PCB are correctly aligned so that the PCB connectors carried by the connection device are properly connected, both mechanically and electrically, with the PCB. Moreover, first and second positioning ribs may act as a constraint against relative displacements of the connection device with respect to the PCB. The presence of the elastic means, whose elastic deformation allows adjusting the mutual distance between the first and second positioning ribs of the connection device, allows the compensation of possible misalignments of the positioning ribs with the positioning recesses due for example to unavoidable manufacturing errors or to different thermal behavior of the connection device with respect to the PCB. The mutual distance between the positioning ribs may be increased or decreased by means of the elastic deformation of the elastic means. The elastic means may thus be extended or compressed. Tolerance issues are accordingly advantageously minimized. Moreover, the presence of the elastic means reduce the risk of fretting corrosion or of contact misalignments during the lifetime of the product because possible displacements of the connection device with respect to the PCB, due for example to temperature changes or the like, are compensated by the elastic properties of the elastic means. A connection device which is thus easy to assemble and, at the same time, reliable and accurate is accordingly provided. By connecting the connection device to the PCB in a single connection operation, all the PCB connectors carried by the connection device are automatically properly connected to the PCB. Examples of PCB connectors that may be connected by means of the connection device according to the present invention are RAST-connectors, for example RAST2.5 or RAST5 connectors.

According to particular embodiments of the present invention, the elastic means may be made of the same material as the other components of the connection device. This facilitates the integration of the elastic means into the connection device thus resulting in an optimization of costs. The elastic means may be made for example of plastic materials, for example thermoplastic resins such as polyamide or polypropylene. These materials are particularly advantageous because of their mechanical behavior in relation with their costs and because of their insulation properties, in particular for the cases where insulation is required.

According to a further embodiment of the invention, a connection device is provided, comprising first and second connection device segments, wherein the first connection device segment comprises the first positioning rib and the second connection device segment comprises the second positioning rib and wherein the first connection device segment is attached to the second connection device segment by means of the elastic means. Each of the segments of the connection device may be adapted to carry any desired number and any desired type of PCB connectors. First and second segments may be adapted for example to carry each the same number of PCB connectors. This is however not mandatory and the number of PCB connectors that may be carried by a segment may be different from the number of PCB connectors that may be carried by the other segment. The total number of PCB connectors that may be carried by the connection device is given by the sum of the PCB connectors that may be carried by each of the segments. First and second connection device segments may be structurally identical but they may also differ from each other. The first connection device segment carries the first positioning rib. The second connection device segment carries the second positioning rib. For example, one or both of the positioning ribs may be made integral with the corresponding segment. Since the first connection device segment is attached to the second connection device segment by means of the elastic means, the elastic deformation (i.e. extension and/or compression) of the elastic means allow adjusting the mutual distance between the two segments and thus the mutual distance between the two positioning ribs. According to a particular embodiment of the invention, the attachment between the two segments is exclusively realized by means of the elastic means. In other words, according to this embodiment, the sole element that guarantees the physical connection between the two segments are the elastic means so that the mutual distance between the two segments and thus between the two positioning ribs is exclusively dependent on the physical and mechanical properties of the elastic means. Other configurations are also possible, for example configurations wherein the elastic deformation of the elastic means is constrained by stopping elements allowing only certain deformations of the elastic means, for example deformations by a given and pre-defined length.

According to a further embodiment of the invention, a connection device is provided, comprising a plurality of housings for housing the PCB connectors to be connected with the printed circuit board. Each of the housings may be configured to house a single PCB connector. Alternatively, any housing may be configured to house a plurality of PCB connectors. Each housing is configured to physically house the PCB connectors so that the PCB connectors housed in the housing are both mechanically and electrically coupled with the connection device. Each of the housings may be for example configured to physically house one or more RAST-connectors, for example RAST2.5 or RAST5 connectors, so that these are both mechanically and electrically coupled with the connection device. The housings may be configured to house more RAST-connectors of the same type. Alternatively, the housings may be configured to house a plurality of different RAST-connectors The first positioning rib may be associated with one or more of the housings. The second positioning rib may be associated with the one or more housings not associated with the first positioning rib. Adjustment of the distance between the positioning ribs by means of the elastic means thus result in the adjustment of the mutual distances between the housings so as to guarantee the appropriate mechanical and electrical connection between the PCB connectors housed in the housings and the PCB. By connecting the connection device to the PCB in a single connection operation, all the PCB connectors housed in the housings of the connection device are automatically connected both mechanically and electrically to the PCB.

According to a further embodiment of the invention, a connection device is provided, further comprising fastening means for securing the connection device to the printed circuit board in a releasable manner. The fastening means may prevent an accidental disconnection of the connection device from the PCB. In other words, the fastening means secure in a stable manner the connection device to the PCB. At the same time, since the fastening means secure the connection device to the printed circuit board in a releasable manner, disassembly of the connection device from the PCB is facilitated. Fastening means may comprise gripping means or any kind of fastening devices that guarantee a stable mechanical connection but, at the same time, are easily releasable in case it is desired to disconnect the connection device from the PCB.

According to a further embodiment of the invention, a connection device is provided, wherein the fastening means are located in the region of the elastic means. This allows increasing the stability of the system since the fastening means that secure the connection device to the PCB are specifically located in the region of the elastic means of the connection device so as to stabilize this region of the device when the connection device is mounted on the PCB.

According to a further embodiment of the invention, a connection device is provided comprising a plurality of positioning ribs and a plurality of elastic means, wherein each of the elastic means is placed between a pair of positioning ribs, so that the distance between positioning ribs, for example between adjacent positioning ribs, is adjustable by means of the deformation of the elastic means. The connection device may be provided with any desired number of positioning ribs wherein each positioning rib is adapted to be housed in a corresponding positioning recess of the PCB. For example, the connection device may comprise three, four, five, six or any other desired number of positioning ribs. The number of positioning ribs of the connection device may correspond to the number of positioning recesses of the PCB. According to an alternative embodiment, the number of positioning ribs of the connection device is lower than the number of positioning recesses of the PCB. Each of the elastic means is placed between a pair of positioning ribs so that the mutual distance between the two positioning ribs of the pair is adjustable by the elastic deformation of the elastic means placed therebetween. For example, if the connection device comprises three positioning ribs, the connection device may comprise two elastic means. In general, if the connection device comprises N positioning ribs, with N being any natural number equal to or greater than 2, the connection device may comprise N-1 elastic means, wherein each elastic means is placed between two adjacent positioning ribs.

According to a further embodiment of the invention, a connection device is provided, comprising a plurality of connection device segments, wherein each connection device segment comprises one of the plurality of positioning ribs and wherein the connection device segments are attached to each other by means of the elastic means. The connection device according to the present invention may comprise any desired number of connection device segments, for example two, three, four, five, six or any other desired number. In general, if the connection device comprises N segments, with N being any natural number equal to or greater than 2, the connection device may comprise N-1 elastic means, wherein each elastic means is placed between two adjacent segments. Increasing in this manner the number of the segments of the system allows improving the tolerance recovery properties of the device since the total deformation of the device is given by the sum of the deformations of the single elastic means and, at the same time, it is possible to control the location of every deformation on the basis of the locations of the single elastic means. The risk of fretting corrosion or the incurrence of contact misalignments during the lifetime of the product are thus strongly minimized. Any desired length of the connection device may be achieved. For example, a total length of 20 cm or more could be achieved. Each of the segments of the connection device may be adapted to carry any desired number and any desired type of PCB connectors, for example RAST-connectors. All the segments may be adapted for example to carry each the same number of PCB connectors. This is however not mandatory and the number of PCB connectors that may be carried by a segment may be different from the number of PCB connectors that may be carried by other segments. The total number of PCB connectors that may be carried by the connection device is given by the sum of the PCB connectors that may be carried by each of the segments. The segments may be structurally identical but they may also differ from each other. For example, any segment may be configured for carrying any desired number and any desired type of PCB connectors, also combining on the same segment different types of PCB connectors. Modularity is guaranteed by the association of at least a positioning rib with each segment. For example, one or more of the positioning ribs may be made integral with the corresponding segment. Since adjacent segments are attached to each other by means of the elastic means, the elastic deformation (i.e. extension and/or compression) of the elastic means allow adjusting the mutual distance between the two adjacent segments and thus the mutual distance between the corresponding positioning ribs. According to a particular embodiment of the invention, the attachment between adjacent segments is exclusively realized by means of the elastic means. In other words, according to this embodiment, the sole element that guarantees the physical connection between the two adjacent segments are the elastic means so that the mutual distance between the two segments and thus between the two positioning ribs is exclusively dependent on the physical and mechanical properties of the elastic means. Other configurations are also possible, for example configurations wherein the elastic deformation of the elastic means is constrained by stopping elements allowing only certain deformations of the elastic means, for example deformations by a given and pre-defined length.

According to a further embodiment of the invention, a connection device is provided, further comprising one or more PCB connectors carried by the connection device so as to be both in mechanical and electrical contact with the connection device. The PCT connectors may be for example RAST-connectors, for example RAST2.5 and/or RAST5 connectors. This system can be advantageously provided by a harness maker to a OEM or to the manufacturer of the final electronic product so that the assembly operations to be carried out by the latter are simplified and less costly.

According to a further embodiment of the invention, a connection device is provided, further comprising one or more receptacles for providing space for PCB connectors which are directly connected to the PCB. Directly connected to the PCB means that the electrical connection between the PCB connectors housed in the one or more receptacles and the PCB is not achieved through the connection device but it is rather a direct connection between the PCB connector and the PCB. In other words, the PCB connectors housed in the receptacles of the connection device are not electrically connected to the connection device, they are directly connected to the PCB. Such PCB connectors are preferably inserted into the receptacles and thus connected to the PCB after the connection device has been connected to the PCB. This guarantees complete freedom in the design of the connection device and/or in the design of the PCB or of the final electronic product. For example, the receptacles may be configured for housing a particular type of PCB connectors, for example RAST5 connectors. However, according to the present invention, the receptacles may be configured for housing any desired type and any desired number of PCB connectors, for example RAST-connectors, such as RAST2.5 and/or RAST5 connectors.

According to a further embodiment of the invention, an electronic module is provided, comprising a connection device according to any embodiment of the invention and a printed circuit board (PCB), wherein the printed circuit board comprises at least first and second positioning recesses for housing the first and second positioning ribs, respectively, of the connection device. This electronic module is particularly easy to assemble. In particular, a single connection operation of the connection device with the PCB allows automatically connecting, both mechanically and electrically, all the PCB connectors carried by the connection device with the PCB. The exact alignment of the connection device with the PCB is guaranteed by the positioning ribs and the corresponding positioning housings. At the same time, tolerance issues, due for example to unavoidable manufacturing errors or to different thermal behaviors of the connection device and the PCB, are minimized by the elastic means of the connection device that allow a precise adjustment of the distance between the positioning ribs exploiting the elastic deformations (i.e. compressions and/or extensions) of the elastic means. Furthermore, elastic deformations of the elastic means reduce the risk of fretting corrosion or of contact misalignments during the lifetime of the module due, for example, to dimensional changes deriving from temperature changes or the like. In the embodiments of the invention wherein the connection device comprises more than two positioning ribs and/or more than two connection device segments, the printed circuit board of the electronic module comprises the corresponding number of positioning recesses so as to guarantee the correct alignment of the connection device with the PCB. According to alternative embodiments of the invention, the PCB may comprise a higher number of positioning recesses than the total number of positioning ribs of the connection device.

According to a further embodiment of the invention, a domestic appliance is provided, comprising a connection device according to any of the embodiments of the invention or an electronic module according any of the embodiments of the invention. The manufacturing process of such a domestic appliance is simplified thanks to the presence of the connection device and/or of the electronic module, so that the corresponding costs are reduced. The connection device or the electronic module according to the present invention is particularly advantageous for domestic appliances comprising PCBs with many connections, in particular when such connections are concentrated on one of the edges of the PCBs.

According to a further embodiment of the invention, a domestic appliance is provided, wherein the domestic appliance is one of: a washing machine, a dishwasher, a refrigerator, a dryer, an oven or a cooking plate.

According to a further embodiment of the invention, a method of assembling a connection device for a printed circuit board with a printed circuit board is provided, wherein the connection device comprises first and second positioning ribs and the printed circuit board comprises first and second positioning recesses, the method comprising the step of inserting the first positioning rib in the first positioning recess and the second positioning rib in the second positioning recess, wherein the method further comprises the step of adjusting the distance between the first and second positioning ribs so as to match the distance between the first and second positioning recesses. This method allows assembling the connection device with the PCB in an easy and, at the same time, extremely reliable manner. All the PCB connectors carried by the connection device, i.e. mechanically and electrically coupled to the connection device, are automatically connected, both mechanically and electrically, to the PCB in a single connection operation that can be carried out, for example, by a manufacturer of the final product comprising the PCB, or by an OEM. Tolerance issues, due for example to unavoidable manufacturing errors or to different thermal behaviors of the connection device and the PCB, are minimized by adjusting the distance between the positioning ribs. The PCT connectors may be for example RAST-connectors, for example RAST2.5 and/or RAST5 connectors.

According to a further embodiment of the invention, a method of assembling a connection device for a printed circuit board with a printed circuit board is provided, wherein the adjustment of the distance between the first and the second positioning ribs so as to match the distance between the first and the second positioning recesses is carried out by deforming elastic means placed between the first and the second positioning ribs. The deformation of the elastic means is an elastic deformation. The elastic deformation may comprise a compression and/or an extension of the elastic means. The presence of the elastic means renders the solution reliable and, at the same time, extremely flexible to several different situations wherein there is any kind of mismatch between the mutual distance of the positioning ribs and the mutual distance of the positioning recesses.

According to a further embodiment of the invention, a method is provided wherein a connection device according to any of the embodiments of the invention is assembled with a printed circuit board, in particular with a printed circuit board comprising at least two positioning recesses.

### BRIEF DESCRIPTION OF THE DRAWINGS

The present invention will be described with reference to the attached figures in which the same reference numerals and/or signs indicate the same part and/or similar and/or corresponding parts of the system. In the figures:
Figure 1A schematically illustrates a rear 3D view of a connection device according to an embodiment of the present invention;
Figure 1B shows an enlargement of the portion marked in figure 1A;
Figure 2 shows a front 3D view of the connection device of figure 1A;
Figure 3 schematically illustrates the connection device of figure 1A carrying a plurality of PCB connectors;
Figure 4A schematically illustrates a PCB according to an embodiment of the present invention;
Figure 4B shows an enlargement of the portion marked in figure 4A;
Figure 5A schematically illustrates an electronic module according to an embodiment of the present invention;
Figure 5B shows an enlargement of the portion marked in figure 5A;
Figure 6 shows a further view of the electronic module of figure 5A;
Figure 7 schematically shows an electronic module according to an embodiment of the present invention;
Figures 8A to 8D schematically show different configurations of the elastic means according to different embodiments of the present invention;
Figure 9 schematically shows a connection device according to an embodiment of the present invention;
Figure 10 schematically shows a connection device according to an embodiment of the present invention;
Figure 11 schematically shows an electronic module according to an embodiment of the present invention.

### DETAILED DESCRIPTION

Hereinafter, the present invention is described with reference to particular embodiments as illustrated in the attached figures. However, the present invention is not limited to the particular embodiments described in the following detailed description and represented in the figures, but rather the embodiments described simply exemplify the various aspects of the present invention, the scope of which is defined by the claims. Further modifications and variations of the present invention will become clear to those skilled in the art.

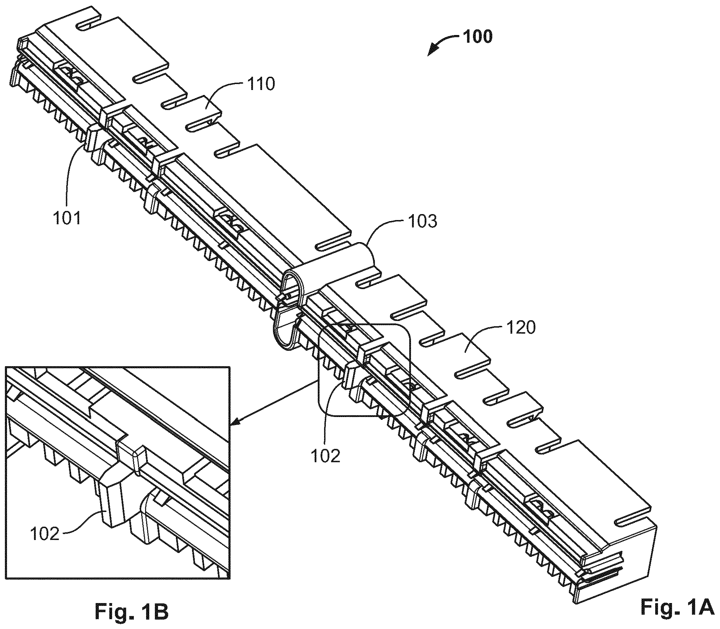

Figure 1A schematically illustrates a rear 3D view of a connection device 100 according to an embodiment of the present invention. The connection device 100 comprises first connection device segment 110 and second connection device segment 120. The first connection device segment 110 is attached to the second connection device segment 120 by means of the elastic means 103. The first connection device segment 110 comprises the first positioning rib 101. The second connection device segment 120 comprises the second positioning rib 102, which is also shown in more detail in the enlargement of figure 1B. In this example, the positioning ribs 101 and 102 are pointed. This shape is particularly advantageous because it simplifies the insertion of the positioning ribs in the corresponding positioning recesses of the PCB, as described below. Nevertheless, other shapes of the positioning ribs are possible. First and second positioning ribs 101 and 102 protrude towards the rear of the connection device 100. First and/or second positioning ribs 101 and 102 may be made integral with the corresponding connection device segment. Alternatively, first and/or second positioning ribs may be fixed to the corresponding connection device segment in any possible manner. Elastic means 103 are placed between the first positioning rib 101 and the second positioning rib 102. Accordingly, the mutual distance between the two positioning ribs may be adjusted by a deformation of the elastic means 103. In particular, a contraction of the elastic means 103 would result in a decrease of the distance between the two positioning ribs. An extension of the elastic means 104 would result in an increase of this distance. In the embodiment of figure 1A, first connection device segment 110 may be pushed toward second connection device segment 120 by compressing elastic means 103 so as to reduce the distance between the ribs 101 and 102. Alternatively, first connection device segment 110 me by pulled away from second connection device segment 120 by extending elastic means 103 so as to increase the distance between the ribs 101 and 102.

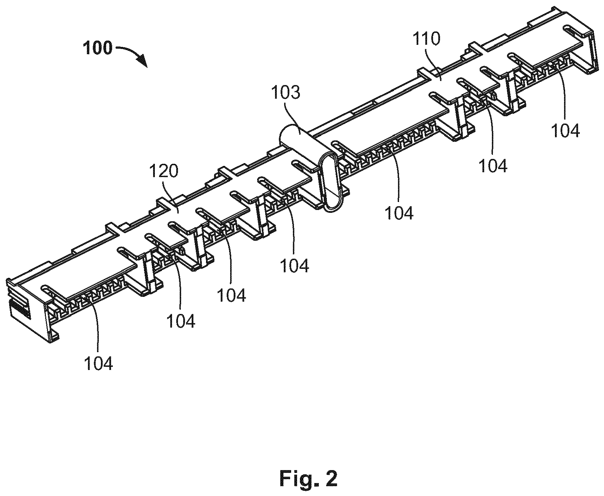

Figure 2 shows a front view of the connection device 100 of figure 1A. As can be seen from the figure, each connection device segment 110 and 120 comprises a plurality of housings 104 for housing PCB connectors not shown in the figure. In particular, in this specific embodiment, first connection device segment 110 comprises three housings 104 and second connection device segment 120 comprises four housings 104. Each of the housings 104 is adapted to house a PCB connector. In particular, each of the housings 104 is configured so that a PCB connector that is housed in the housing 104 is both in mechanical and electrical connection with the connection device 100. In other words, a PCB connector housed in one of the housings 104 is not only mechanically fixed to and supported by the connection device 100, but it is also in electrical connection with the connection device 100, so that when the connection device 100 is in turn connected to a PCB there is automatically an electrical connection between the PCB connector and the PCB.

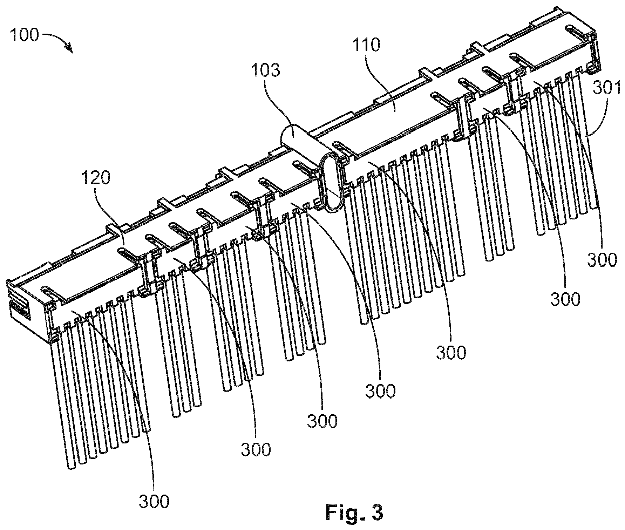

Figure 3 shows the system of figure 2 wherein a plurality of PCB connectors 300 is carried by the connection device 100. In particular, each of the housings 104 shown in figure 2 houses a PCB connector 300. As can be seen in the figure, each of the PCB connectors 300 is provided with a certain number of connection wires 301 for carrying the signals input to and/or output from the PCB connector 300. Even if the figure shows that each of the housings 104 carries a connector 300, according to alternative embodiments of the invention one or more of the housings 104 may lack a corresponding PCB connector. Moreover, even if the figure schematically shows that all the connectors housed in the housings 104 are of the same type, for example RAST2.5 connectors, according to present invention the housings may be configured for housing also different types of connectors, for example RAST5 connectors, and also for housing combinations of different types of connectors, for example RAST2.5 and RAST5 connectors.

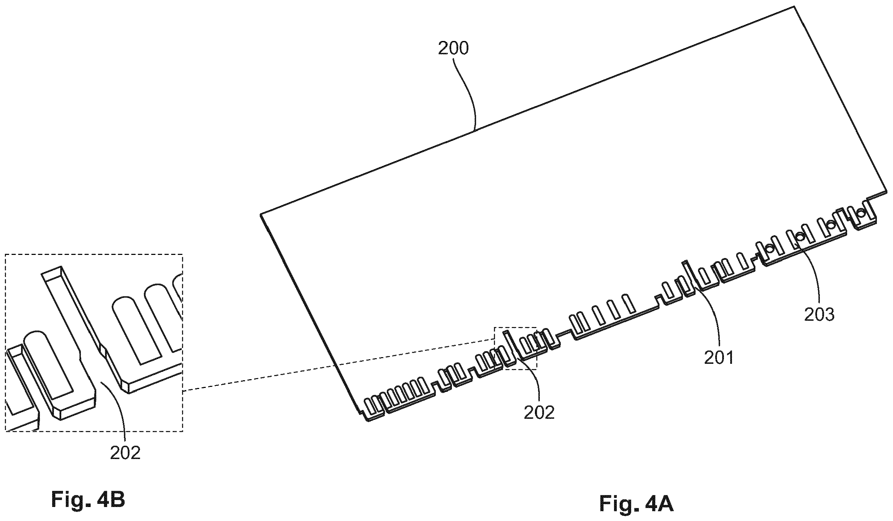

Figure 4A schematically illustrates a printed circuit board (PCB) 200 according to an embodiment of the invention. The PCB 200 comprises first positioning recess 201 and second positioning recess 202 for housing first positioning rib 101 and second positioning rib 102, respectively, of the connection device 100. Second positioning recess 202 is shown in more detail in the enlargement of figure 4B. As can be seen from the figures, first positioning recess 201 and second positioning recess 202 are configured to house first positioning rib 101 and second positioning rib 102, respectively. In particular, first positioning recess 201 and second positioning recess 202 may be dimensioned and/or shaped so as to match the dimension and/or shape of the positioning ribs 101 and 102. Even if in the embodiments shown in the figures the ribs 101 and 102 are identical and the recesses 201 and 202 are identical as well, according to further embodiments of the invention, each of the ribs could have a specific shape and/or a specific dimension which is then matched by the corresponding positioning recess of the PCB 200.

For example, the width of the recesses 201 and 202 could be in the range of 1,5 mm. The depth of the recesses 201 and 202 depends on the degree of overlap between the PCB and the connection device and may be for example in the range of 10 mm.

In the embodiment shown in figures 4A and 4B first positioning recess 201 and second positioning recess 202 comprise a first portion in correspondence to the edge of the PCB and a second terminal portion, wherein the lateral width of the first portion is larger than the lateral width of the second terminal portion. Moreover, there is a transition region between the two portions wherein the lateral width decreases in a continuous manner. This configuration is advantageous because it simplifies the insertion of the positioning ribs. Nevertheless, other configurations of the positioning recesses, for example configurations wherein the lateral width of the recess is constant along the length of the recess or continuously decreases from the edge of the PCB 200 to the end of the recess, are also possible. The positioning recesses may also comprise a wide opening directly at the edge of the PCB 200, for example as shown in figure 4B, to facilitate insertion of the positioning ribs. Providing the recesses and/or the positioning ribs with chamfered edges simplifies and improves the insertion process.

Even if figure 4A schematically shows contact pads 203 of the PCB 200 for the electrical contact between the connection device 100 and the PCB 200, the electronic architecture of the PCB 200 is not described in further details because it is not limiting for the present invention and it is apparent for the skilled person that every possible electronic architecture of a PCB can be implemented in the ambit of the present invention.

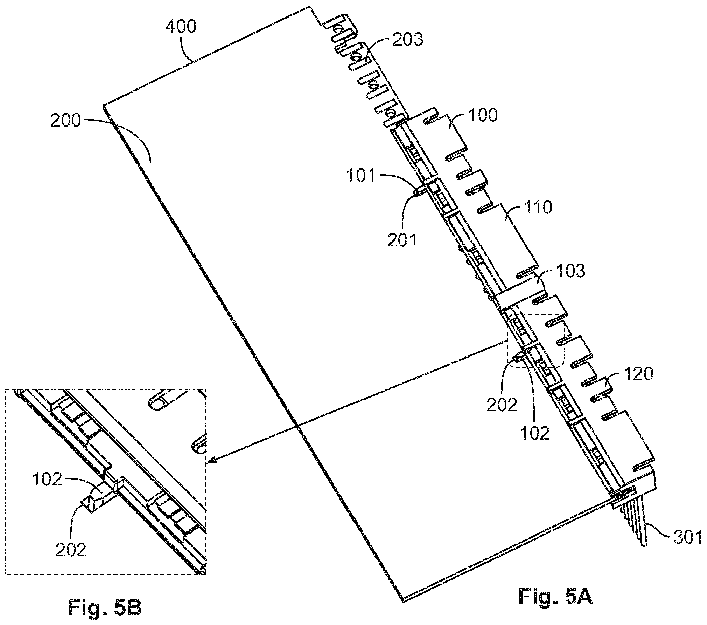

Figure 5A schematically shows an electronic module 400 according to an embodiment of the present invention. In particular, the electronic module 400 of figure 5A comprises the connection device 100 of figure 1A connected to the PCB 200 of figure 4A. As can be seen, the positioning ribs 101 and 102 of the connection device 100 are housed in the corresponding positioning recesses 201 and 202, respectively, of the PCB 200. The connection device 100 is both mechanically and electrically coupled to the PCB 200. If, for any reason, when assembling the connection device 100 to the PCB 200 the distance between the positioning ribs 101 and 102 does not exactly matches the distance between the positioning recesses 201 and 202, exploiting the elastic deformation of the elastic element 103 it is possible to adjust the distance between the positioning ribs 101 and 102, so that the distances match and the ribs can be properly inserted in the corresponding recesses. Moreover, the presence of the positioning ribs 101 and 102 of the connection device 100 inserted into the corresponding recesses 201 and 202 of the PCB act as a constraint against possible displacements and/or misalignments of the connection device 100 with respect to the PCB 200 during the lifetime of the system. At the same time, since the system is provided with the elastic means 103, the elastic behaviour of same compensate for such possible displacements, due for example to temperature variations or the like, thus reducing the risk of fretting corrosion or misalignments during the lifetime of the system.

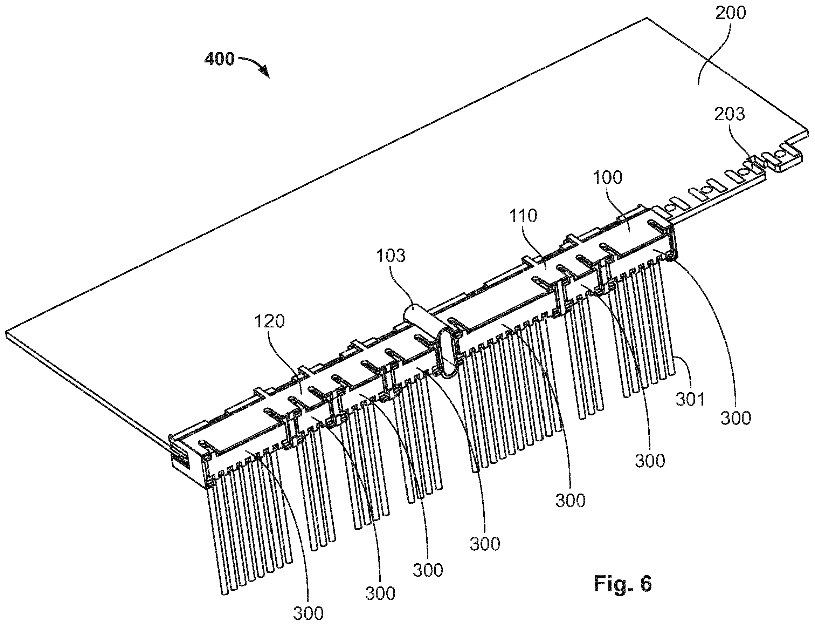

Figure 6 shows a further view of the electronic module 400 of figure 5A. In particular, figure 6 shows the PCB connectors 300 housed in the connection device 100. Each of the PCB connectors 300 is both mechanically and electrically coupled to the PCB 200 via the connection device 100. Accordingly, signals to be input to the PCB 200 may be input via the connection wires 301 of the PCB connectors. Similarly, signals which are output from the PCB 200 may be collected via the connection wires 301 of the PCB connectors. As can be seen, the single operation of assembling the connection device 100 with the PCB 200 allows realizing the electrical contacts between all the PCB connectors 300 carried by the connection device 100 and the PCB 200 in a single step. For example, a harness maker could provide a system in the configuration of figure 3 and the manufacturer of the final electronic product could achieve the connection of all the PCB connectors 300 with the PCB 200 schematically shown in figure 6 simply by means of a single assembly step.

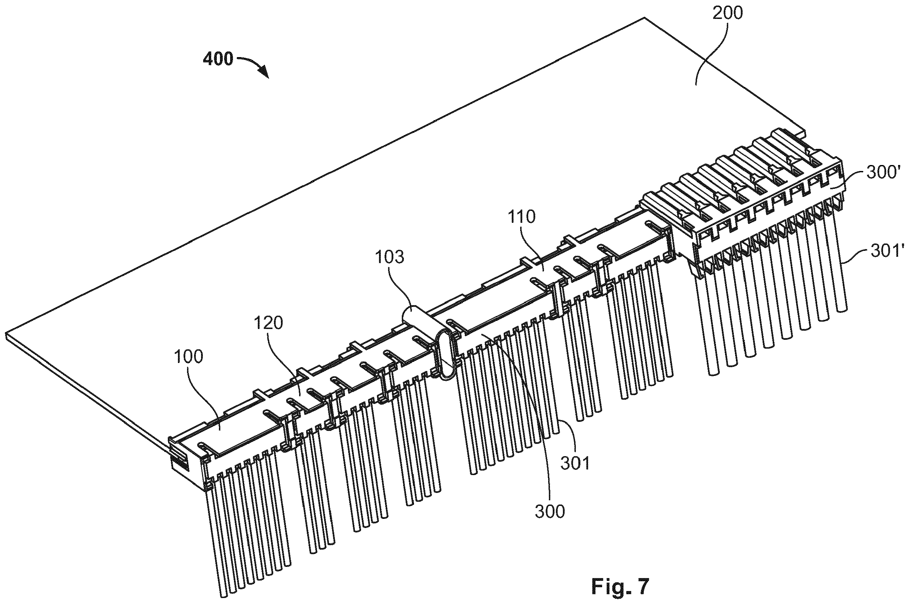

Figure 7 schematically shows an electronic module 400 according to a further embodiment of the invention. In particular, figure 7 shows the system of figure 6 with a further PCB connector 300', with the corresponding connection wires 301', connected to the PCB 200. Connector 300' could be for example dedicated to power supply for the PCB 200. Connector 300' is connected to PCB 200 with a further connection step so that the configuration of figure 7 is obtained by two connection steps: a step of connecting the connection device 100 to the PCB 200 and a step of connecting the connector 300' to the PCB 200. This is an example of the flexibility of the present invention. In particular, this shows that even if a certain number of PCB connectors 300 may be easily and precisely connected to the PCB 200 with a single assembly step by means of a connection device 100 according to the present invention, any other number of PCB connectors 300' could be connected to the PCB 200 by corresponding dedicated assembly steps. Moreover, even more than one connection devices according to the present invention could be connected to a single PCB.

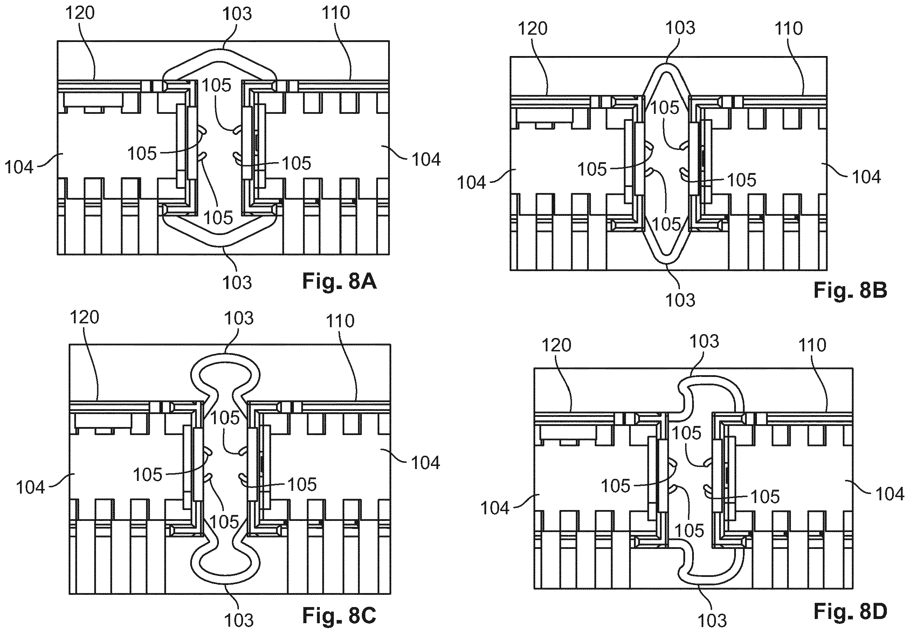

Figures 8A to 8D schematically show different possible configurations of the elastic means 103 in cross sections according to particular embodiments of the present invention. As shown in the figures, the elastic means 103 may exhibit various configurations. As will be appreciated by those skilled in the art, different configurations of the elastic means may correspond to different elastic properties and behaviours which would thus reflect in the adjustment of the distance between the positioning ribs. The figures further show that, according to embodiments of the invention, the elastic means 103 may be placed so that a first elastic means portion adjoins the upper portions of the connection device segments 110 and 120 and a second elastic means portion adjoins the lower portions of the connection device segments 110 and 120.

Figures 8A to 8D also show that, according to embodiments of the invention, the system may be provided with fastening means 105 for securing the connection device 100 to the PCB 200 in a releasable manner. For example, fastening means 105 may be elastic pins which, pairwise, hold the PCB 200. In particular, pair of elastic pins act on the thickness of the PCB 200 so as to hold the PCB 200. The PCB 200 is inserted between the pins. In this way, a simple and reliable releasable coupling is achieved. In the examples of figures 8A to 8D, the fastening means 105 are located in the region of the elastic means 103. Nevertheless, according to further embodiments of the invention, the fastening means 105 may be located in other regions of the connection device 100. Moreover, the presence and/or the structure of the fastening means 105 is completely independent of the particular configuration of the elastic means 103. In other words, even if the fastening means are shown in combination with the specific configurations of the elastic means 103 as depicted in figures 8A to 8D, fastening means 105 could be provided with any possible configuration of the elastic means 103.

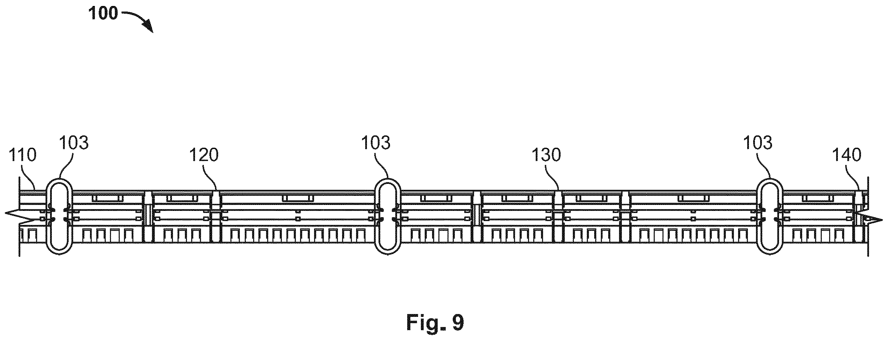

Figure 9 schematically shows a connection device 100 according to a further embodiment of the invention. This embodiment comprises a plurality of positioning ribs and a plurality of elastic means 103, wherein each of the elastic means is placed between a pair of positioning ribs so that the distance between the positioning ribs is adjustable by means of the deformation of the elastic means 103. In particular, the embodiment of figure 9 comprises a plurality of connection device segments wherein each connection device segment comprises a positioning rib and wherein the connection device segments are attached to each other by means of the elastic means 103. Still more in particular, connection device 100 of figure 9 comprises first connection device segment 110, second connection device segment 120, third connection device segment 130 and fourth connection device 140. Each of the segments comprises at least a positioning rib (not shown in the figure). First connection device segment 110 is attached to second connection device segment 120 by means of elastic means 103. Second connection device segment 120 is attached to third connection device segment 130 by means of elastic means 103. Third connection device segment 130 is attached to fourth connection device segment 140 by means of elastic means 103. Such a configuration with a plurality of connection device segments and a plurality of elastic means therebetween is particularly advantageous for particularly long connection devices. Tolerance issues between the mutual distances of the positioning ribs and the distances of corresponding positioning recesses of the PCB could be easily and accurately dealt with by exploiting the elastic deformations of the various elastic means 103 of the system.

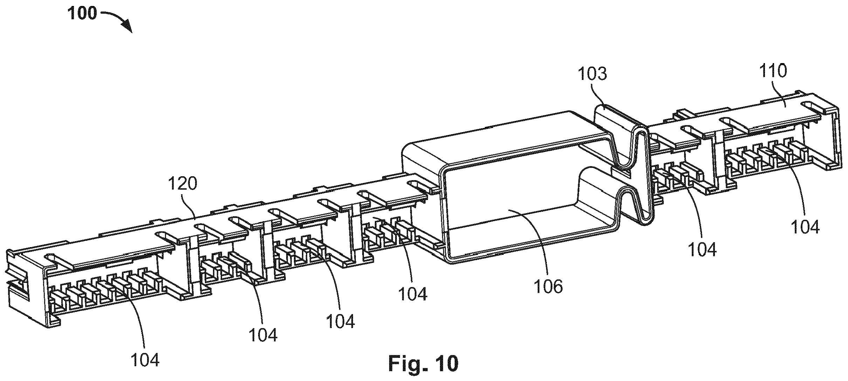

Figure 10 schematically shows a further embodiment of the present invention. Even if this embodiment still comprises a first connection device segment 110 attached to a second device segment 120 by means of elastic means 103, the second device segment 120 does not only comprise four housings 104 adapted to provide both mechanical and electrical connection between the connection device 100 and the PCB connectors housed in the housings 104, but also a receptacle 106. Receptacle 106 is adapted to house a PCB connector 300" which is connected to the system after the connection device 100 has been connected. In other words, differently from the housings 104, receptacle 106 is not configured to provide mechanical and electrical connection between the PCB connector 300" housed therein and the PCB 200, but only to provide space for such a connector which is to be attached to the system after the connection device 100 has been connected to the PCB 200. This still further shows the modularity and flexibility according to the present invention. The system could be provided in fact with any number of housings and any number of receptacles according to the design which is desired. The receptacles could be configured for housing any type of PCB connector. For example, the receptacles could be configured for housing RAST-connectors, for example RAST5 and/or RAST2.5 connectors.

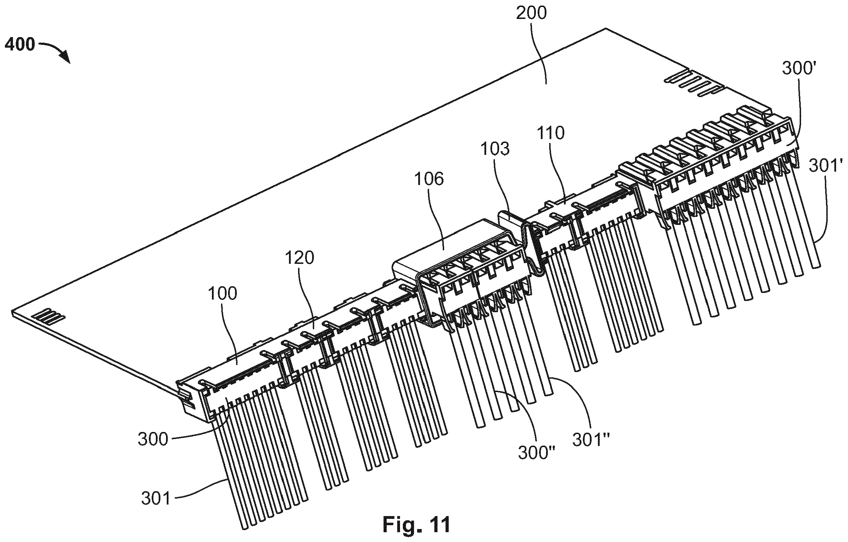

A configuration of an electronic module 400 with the connection device of figure 10 is shown in figure 11. The system does not only comprise PCB connectors 300 connected to the PCB 200 via the connection device 100, but also PCB connector 300' which is directly attached and electrically connected to the PCB 200 independently of the connection device 100 and PCB connector 300" which is mechanically coupled to the PCB 200 via receptacle 106 of the connection device 100 but which is directly electrically connected to the PCB 200. The assembly process of the module 400 may thus comprise three steps: a step of connecting the connection device 100 previously provided with the PCB connectors 300 to the PCB 200, a step of connecting the PCB connector 300' to the PCB 200 and a step of inserting the PCB connector 300" into the receptacle 106 and connecting it to the PCB 200.

Even if the present invention has been described with reference to the embodiments described above, it is clear to those skilled in the art that it is possible to make several modifications, variations and improvements of the present invention in light of the teaching described above and in the ambit of the attached claims without departing from the object and the scope of protection of the invention.

For example, several configurations of the connection device with any number of connection device segments are possible. The segments of a single connection device may all have the same structure. Alternatively, the segments may differ from each other or there can be a certain number of equal segments attached to a certain number of different segments. Moreover, each connection device segment may in turn comprise any number of housings and/or any number of receptacles, or any combination thereof. For example, different types of housings, such as housings for different types of PCB connectors, for example RAST2.5 and RAST5 connectors, may be combined. Moreover, also different types of housings may be combined with different types of receptacles. Furthermore, the electronic modules may comprise one or more connection devices according to the invention and any desired number of PCB connectors directly connected to a PCB.

Finally, anything that is deemed known by those skilled in the art has not been described in order to avoid needlessly excessively obfuscating the described invention. For example, no details have been provided on the possible electronic architecture of the PCB or of the PCB connectors since, as it will be apparent to those skilled in the art, several types of PCBs known to the skilled person and/or several types of PCB connectors, also known by the skilled person, may be adopted in the ambit of the present invention. Same hold true for the countless types of electrical components that may be carried by the PCBs.

Consequently, the invention is not limited to the embodiments described above, but is only limited by the scope of protection of the attached claims.

### REFERENCE SIGNS

- 100:: Connection device
- 101:: First positioning rib
- 102:: Second positioning rib
- 103:: Elastic means
- 104:: Housings
- 105:: Fastening means
- 106:: Receptacle
- 110:: First connection device segment
- 120:: Second connection device segment
- 130:: Third connection device segment
- 140:: Fourth connection device segment
- 200:: Printed circuit board
- 201:: First positioning recess
- 202:: Second positioning recess
- 300, 300', 300":: PCB connectors
- 301, 301', 301":: Connection wire
- 400:: Electronic module

## Claims

1. Connection device (100) for a printed circuit board (200) for connecting a plurality of PCB connectors (300) with a printed circuit board (200), said connection device (100) comprising first and second positioning ribs (101, 102) adapted to be housed in first and second positioning recesses (201, 202), respectively, of said printed circuit board (200), **characterized in that:** said connection device (100) comprises elastic means (103) placed between said first and second positioning ribs (101, 102), so that the distance between said first and second positioning ribs (101, 102) is adjustable by means of the deformation of said elastic means (103).

2. Connection device (100) according to claim 1, comprising first and second connection device segments (110, 120), wherein said first connection device segment (110) comprises said first positioning rib (101) and said second connection device segment (120) comprises said second positioning rib (102) and wherein said first connection device segment (110) is attached to said second connection device segment (120) by means of said elastic means (103).

3. Connection device (100) according to one of the preceding claims, comprising a plurality of housings (104) for housing said PCB connectors (300) to be connected with said printed circuit board (200).

4. Connection device (100) according to one of the preceding claims, further comprising fastening means (105) for securing said connection device (100) to said printed circuit board (200) in a releasable manner.

5. Connection device (100) according to claim 4, wherein said fastening means (105) are located in the region of said elastic means (103).

6. Connection device (100) according to one of the preceding claims, comprising a plurality of positioning ribs (101, 102) and a plurality of elastic means (103), wherein each of the elastic means (103) is placed between a pair of positioning ribs (101, 102) so that the distance between positioning ribs (101, 102) is adjustable by means of the deformation of said elastic means (103).

7. Connection device (100) according to claim 6, comprising a plurality of connection device segments (110, 120, 130, 140), wherein each connection device segment (110, 120, 130, 140) comprises one of the plurality of positioning ribs (101, 102) and wherein said connection device segments (110, 120, 130, 140) are attached to each other by means of said elastic means (103).

8. Connection device (100) according to one of the preceding claims, further comprising one or more PCB connectors (300) carried by said connection device (100) so as to be both in mechanical and electrical contact with said connection device (100).

9. Connection device (100) according to one of the preceding claims, further comprising one or more receptacles (106) for providing space for PCB connectors (300") which are directly connected to the PCB (200).

10. Electronic module (400) comprising a connection device (100) according to one of the preceding claims and a printed circuit board (200), wherein said printed circuit board (200) comprises at least first and second positioning recesses (201, 202) for housing said first and second positioning ribs (101, 102), respectively, of said connection device (100).

11. Domestic appliance comprising a connection device (100) according to one of claims 1 to 9 or an electronic module according to claim 10.

12. Domestic appliance according to claim 11, wherein said domestic appliance is one of: a washing machine, a dishwasher, a refrigerator, a dryer, an oven or a cooking plate.

13. Method of assembling a connection device (100) for a printed circuit board (200) with a printed circuit board (200), said connection device (100) comprising first and second positioning ribs (101, 102), said printed circuit board (200) comprising first and second positioning recesses (201, 202), said method comprising the following step:
inserting said first positioning rib (101) in said first positioning recesses (201) and said second positioning rib (102) in said second positioning recess (202),
**characterized in that:**
said method further comprises the following step:
adjusting the distance between said first and second positioning ribs (101, 102) so as to match the distance between said first and second positioning recesses (201, 202).

14. Method according to claim 13, wherein the adjustment of the distance between said first and second positioning ribs (101, 102) so as to match the distance between said first and second positioning recesses (201, 202) is carried out by deforming elastic means (103) placed between said first and second positioning ribs (101, 102).
